# EUROPEAN PATENT APPLICATION

(11) **EP 3 336 535 A1**
(43) Date of publication of application: **20.06.2018**
(21) Application number: 17206336.4
(22) Date of filing: 11.12.2017
(51) Int. Cl.: G01N 27/90

(54) **A FLEXIBLE EDDY CURRENT PROBE AND A METHOD OF USING THE SAME**

(30) Priority: 14.12.2016 GB 201621213
(71) Applicant: Rolls-Royce plc, London SW1E 6AT (GB)
(72) Inventor: WONG, Chow Cher, Derby, Derbyshire DE24 8BJ (GB); HASSAN, Waled, Derby, Derbyshire DE24 8BJ (GB); FAN, David, Derby, Derbyshire DE24 8BJ (GB); CASTAGNE, Sylvie J, Derby, Derbyshire DE24 8BJ (GB); NAGARAJAN, Balasubramanian, Derby, Derbyshire DE24 8BJ (GB); ANNAMALAI, Swaminathan, Derby, Derbyshire DE24 8BJ (GB)
(74) Representative: Rolls-Royce plc

(57) **Abstract**

An eddy current probe comprises a first planar coil (210), a second planar coil (230) and a flexible substrate. The first coil comprises a first conductor (214) having a spiral geometry, and the second coil comprises a second conductor (234) having a spiral geometry. The first conductor is arranged concentrically with the second conductor, with the first conductor being juxtaposed with the second conductor, and the concentrically arranged first and second conductors are embedded within the flexible substrate.

## Description

### Field of the Disclosure

The present disclosure relates to an eddy current probe and particularly, but not exclusively, to an eddy current probe for measuring residual stresses, together with a method of using such a probe.

### Background to the Disclosure

Residual stresses are stresses that are present in a material or a component without the application of external forces or loads. The scale of residual stress in a material or component may vary from a macro scale in which the residual stress varies over a distance much larger than the material's grain size, through a micro scale in which the residual stress varies over a range approximately equal to the material's grain size, to a nano scale in which that residual stress varies over several atomic distances across material grains.

The presence of residual stresses in a material or component may be desirable or undesirable. For example, tensile residual stresses near the surface of a component may accelerate the initiation and growth phases of fatigue cracks, which is detrimental. In contrast, compressive residual stresses near the surface of a component may extend the fatigue life of the component.

The purpose of this disclosure is to implement an online Nondestructive Evaluation (NDE) method to measure RS depth profile of surface enhanced components. During surface enhancement, compressive residual stresses are induced into the component to improve the fatigue life as well as foreign object damage tolerance. Most common surface enhancement methods are shot peening (SP), laser shock peening (LSP), low plasticity burnishing (LPB) and Deep Cold Rolling (DCR). The next step is to monitor the remaining residual stress profile during scheduled inspection period to reliably assess the remaining life of the component. Existing methods to measure residual stress are mostly destructive. The most common near-surface residual stress assessment method is based on X-ray diffraction (XRD). However, XRD measurements offer penetration depths of only 5-20 microns and in order to evaluate the whole residual stress depth profile of surface treated components requires successive material layer removal. To overcome this limitation, one can increase the intensity of the incident beam such as in synchrotron radiation or neutron diffraction, where the penetration depths can reach a few centimetres, but access to such sources badly limits the applicability of these methods. Also the spatial resolution of these techniques is not so good.

A NDE method using eddy current is used to measure residual stress of surface treated components. It has great potential because of the stress dependence on electrical conductivity. Standard depth of penetration of eddy current is inversely proportional to the frequency. So penetration depths can be varied by changing coil frequency. To capture the peak compressive stresses of surface treated nickel alloys, the inspection frequency has to be as high as 50-75 MHz, well beyond the scope of commercially available probes.

### Statements of Disclosure

According to a first aspect of the present disclosure there is provided an eddy current probe comprising:
a first planar coil;
a second planar coil; and
a flexible substrate,
wherein the first coil comprises a first conductor having a spiral geometry, the second coil comprises a second conductor having a spiral geometry, the first conductor is arranged concentrically with the second conductor, with the first conductor being juxtaposed with the second conductor, and the concentrically arranged first and second planar coils are embedded within the flexible substrate.

By arranging the first and second planar coils concentrically with one another, and embedding the first and second coils within a flexible substrate, the eddy current probe is flexible and conformable to a surface of a component. This conformable positioning against the surface of the component makes the eddy current probe more efficient at generating a magnetic field in the component, and in sending a change in this magnetic field resulting from a residual stress condition in the component.

The juxtaposition of the first coil segments and second coil segments makes the eddy current probe more compact and, as outlined above, more efficient at generating and sensing magnetic fields in the component.

Optionally, the spiral geometry is a rectilinear spiral geometry.

A rectilinear spiral geometry of the first and second coils results in the eddy current streamlines that are induced in the component, having the form of rounded rectilinear profiles. In other words, if the first and second coils are planar rectangular coils, the resulting induced eddy current streamlines are rounded rectangles. Likewise, if the first and second coils are planar square coils, the resulting eddy current streamlines are rounded squares.

Generating eddy current streamlines having linear elements (i.e. the sides of the squares or rectangles in the examples above) means that these linear eddy current streamlines can be aligned with the directional variation in residual stress in the component. This enables the eddy current probe to more accurately determine this variation in residual stress in the component.

Optionally, the first and second planar coils are completely embedded within the flexible substrate.

By completely embedding the first and second planar coils within the flexible substrate, the eddy current probe is more resistant to mechanical damage, and easier to handle during operational use.

Optionally, each of the first conductor and the second conductor has a width of between 30µm and 150µm.

Optionally, each of the first conductor and the second conductor has a height of between 30µm and 150µm.

The rectilinear cross-sectional profile of the first and second coil segments enables the coil segments to be more readily embedded within the flexible substrate, which in turn makes the eddy current probe easier and more cost effective to fabricate.

Optionally, each of the first planar coil and the second planar coil has a pair of electrical connections connected to opposing ends of the respective first and second conductors, and each respective pair of electrical connections is positioned on opposing sides of the concentrically arranged first and second planar coils.

Separating the electrical connections for the first and second planar coils onto opposite sides of the eddy current probe minimises crossover interference between the electrical current in each of the first and second planar coils. This improves the accuracy of the first and second coils in both generating and sensing changes in magnetic field within a surface layer of the component.

According to a second embodiment of the disclosure there is provided an eddy current system, the system comprising
an eddy current probe according to the first aspect; and
a control unit,
wherein the control unit is electrically connected to each of the first planar coil and the second planar coil, and the control unit is configured to transmit a first alternating current signal to one of the first planar coil and the second planar coil, and to receive a second alternating current signal from the other one of the first planar coil and the second planar coil.

The eddy current system takes advantage of the above-mentioned improved generation and sensing of magnetic fields in a surface layer of a component, that is provided by the eddy current probe of the disclosure, to enable a user to more accurately detect and measure residual stresses in the surface layer of the component.

Additionally, the packaging advantages described above in connection with the eddy current probe of the disclosure enable a user to employ the eddy current probe in a wider range of operational situations and conditions than conventional eddy current probes.

Optionally, the eddy current system further comprises a component, wherein the first planar coil is an excitation coil and the second planar coil is a pickup coil, the eddy current probe is positioned conformally over a surface of the component, the first alternating current signal being arranged to generate eddy currents in the component, the second alternating current being representative of a residual stress condition within the component, and the control unit being further configured to process the second alternating current to provide a measure of the residual stress condition within the component..

Optionally, each of the first alternating current signal and the second alternating current signal has a sinusoidal signal profile.

For improved eddy current coil performance and for the application of the present disclosure (characterizing material changes based on the change in the coil's characteristic impedance), a sinusoidal waveform signal (continuous) is the optimum choice compared to a discrete waveform such as triangle, square or sawtooth waveform signal.

According to a third aspect of the present disclosure there is provided a method of inspecting a component, the method comprising the steps of:
providing an eddy current probe according to the first aspect, positioning the eddy current probe conformally over a surface of the component;
generating a first alternating current signal in the first planar coil;
receiving a second alternating current signal in the second planar coil; and
processing the second alternating current signal to provide an indication of the magnitude and distribution of residual stress in the component.

The method of inspecting the component involves the detection of residual stresses in a surface layer of the component.

The above-mentioned advantages of the eddy current probe of the disclosure make the method of the disclosure more efficient at characterising residual stresses in a surface layer of a component.

According to a fourth aspect of the present disclosure there is provided a computer program that, when read by a computer, causes performance of the method according to the third aspect.

According to a fifth aspect of the present disclosure there is provided a non-transitory computer readable storage medium comprising computer readable instructions that, when read by a computer, cause performance of the method according to the third aspect.

According to a sixth aspect of the present disclosure there is provided a signal comprising computer readable instructions that, when read by a computer, cause performance of the method according to the third aspect.

Other aspects of the disclosure provide devices, methods and systems which include and/or implement some or all of the actions described herein. The illustrative aspects of the disclosure are designed to solve one or more of the problems herein described and/or one or more other problems not discussed.

### Brief Description of the Drawings

There now follows a description of an embodiment of the disclosure, by way of nonlimiting example, with reference being made to the accompanying drawings in which:
Figure 1 shows a schematic view of an eddy current technique for measuring residual stress in a component, according to the prior art;
Figure 2 shows a schematic view of an eddy current probe according to a first embodiment of the disclosure;
Figure 3 shows a schematic view of an eddy current probe according to a second embodiment of the disclosure;
Figure 4 shows a schematic cross-sectional view on the eddy current probe of Figure 2;
Figure 5 shows a schematic view of an eddy current system according to a third embodiment of the disclosure; and
Figure 6 shows a typical impedance plane display produced by the system of Figure 5 .

It is noted that the drawings may not be to scale. The drawings are intended to depict only typical aspects of the disclosure, and therefore should not be considered as limiting the scope of the disclosure. In the drawings, like numbering represents like elements between the drawings.

### Detailed Description

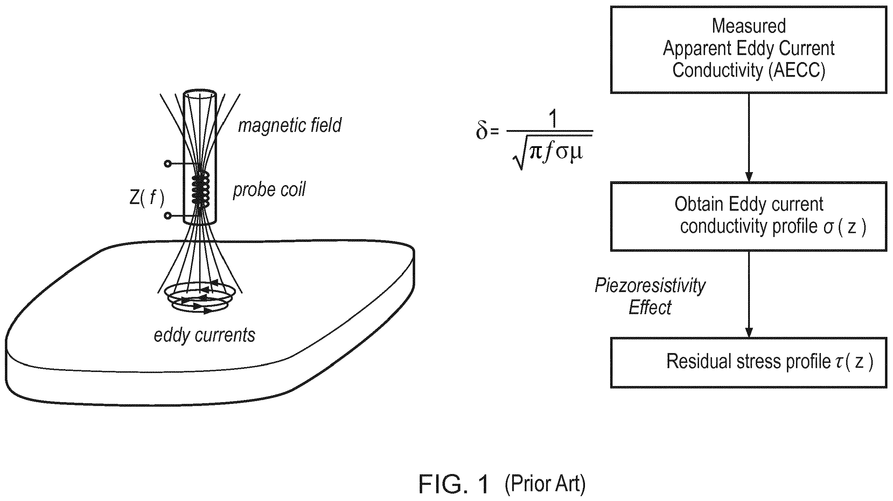

Eddy currents are electrical currents induced in a conductor by a varying magnetic field. They are circular in nature and their paths are oriented perpendicular to the direction of the magnetic field. The source of the varying magnetic field is the electromagnetic field produced by a coil carrying an alternating electric current (see Figure 1). When an electrical conductive component is placed near this coil, the varying magnetic field intersects the conductive material inducing eddy currents. Eddy current non-destructive inspection can determine various properties of the component such as residual stress, and may also be used to locate flaws in the component and to measure dimensions of the component.

The strength of the electromagnetic field at the surface of the conductor depends on coil size and configuration, amount of current through the coil and the distance of the coil from the material surface.

The basic mode of operation of the eddy current equipment when measuring the residual stress in a component is termed conductivity mode. In this mode, the measured probe coil electrical impedance is transformed to another parameter known as apparent eddy current conductivity (AECC). The detail of this technique is well known and will not be described further.

The conductivity profile in the component can be predicted from the measured frequency dependent AECC. The conductivity profile is influenced by different factors such as residual stress, microstructure, cold work and surface roughness of the material. A simple schematic representation of the method to obtain eddy current stress depth profile is shown in the flow chart of Figure 1.

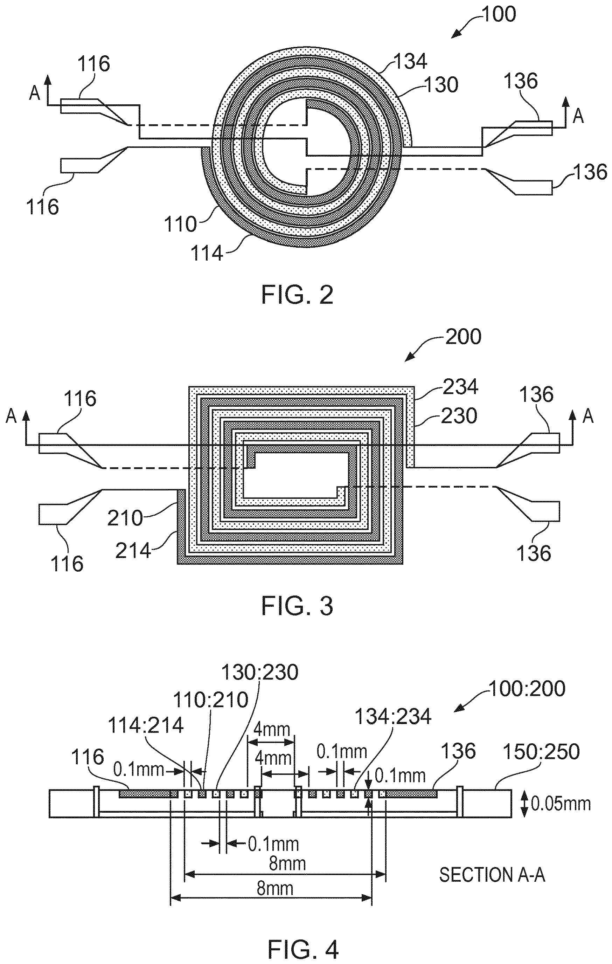

Referring to Figures 2 and 4, an eddy current probe according to a first embodiment of the disclosure is designated generally by the reference numeral 100.

The eddy current probe 100 comprises a first planar coil 110, a second planar coil 130, and a flexible substrate 150.

The first coil 110 comprises a first conductor 114 having a spiral circular geometry. The second coil 130 comprises a second conductor 134 also having a spiral circular geometry. The first conductor 114 and the second conductor 134 have corresponding spiral circular geometries.

The first conductor 114 is arranged concentrically with the second conductor 134, with the first conductor 114 being juxtaposed with the second conductor 134. In other words the first conductor 114 and the second conductor 134 are arranged side by side in a spiral circular configuration.

The first conductor 114 is formed with a rectilinear cross-sectional profile. In the present embodiment, the cross-sectional profile of the first conductor 114 has a width of 100µm and a depth of 100µm. The second conductor 134 is formed with a rectilinear cross-sectional profile. In the present embodiment, the cross-sectional profile of the second conductor 134 has a width of 100µm and a depth of 100µm.

In the embodiment shown in Figure 2, each of the first coil 110 and the second coil 130 is arranged in a circular spiral configuration. The first coil 110 has an outer diameter of 8mm. The second coil 130 also has an outer diameter of 8mm.

The first conductor 114 is provided with a pair of electrical connections 116 at the opposing ends of the first conductor 114.

The second conductor 134 is provided with a pair of electrical connections 136 at the opposing ends of the second conductor 134.

As shown in Figure 4, each of the first conductor 114 and the second conductor 134 is partially embedded in the flexible substrate 150.

In use, the first coil 110 is designated as an excitation coil, and the second coil 130 is designated as a pickup coil. Since the first coil 110 and the second coil 130 are identical to one another this designation may readily be reversed.

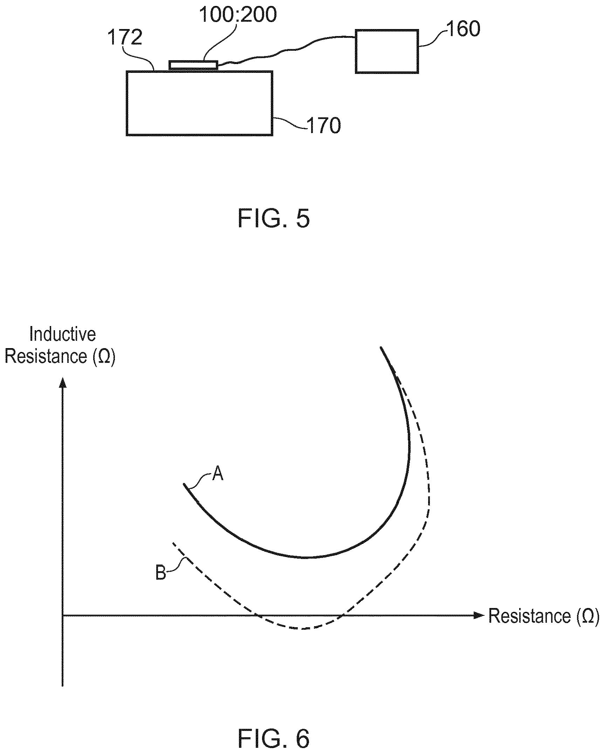

As shown in Figure 5, the eddy current probe 100 is connected to a controller 160. The controller 160 may be a computer or may be a sub-system of a further control system (not shown).

Referring to Figures 3 and 4, an eddy current probe according to a second embodiment of the disclosure is designated generally by the reference numeral 200. Features of the eddy current probe 200 which correspond to those of eddy current probe 100 have been given corresponding reference numerals for ease of reference.

The eddy current probe 200 has a first planar coil 210, a second planar coil 230, and a flexible substrate 250.

The first coil 210 comprises a first conductor 214 having a spiral rectilinear geometry. The second coil 230 comprises a second conductor 234 also having a spiral rectilinear geometry. The first conductor 214 and the second conductor 234 have corresponding rectilinear spiral geometries.

The first conductor 214 is arranged concentrically with the second conductor 234, with the first conductor 214 being juxtaposed with the second conductor 234. In other words the first conductor 214 and the second conductor 234 are arranged side by side in a spiral rectilinear configuration.

The first conductor 214 is formed with a rectilinear cross-sectional profile. In the present embodiment, the cross-sectional profile of the first conductor 214 has a width of 100µm and a depth of 100µm. The second conductor 234 is formed with a rectilinear cross-sectional profile. In the present embodiment, the cross-sectional profile of the second conductor 234 has a width of 100µm and a depth of 100µm.

In the embodiment shown in Figure 3, each of the first coil 210 and the second coil 230 is arranged in a rectilinear spiral configuration. The first coil 210 has a length of 8mm. The second coil 230 also has a length of 8mm.

The first conductor 214 is provided with a pair of electrical connections 116 at the opposing ends of the first conductor 214.

The second conductor 234 is provided with a pair of electrical connections 136 at the opposing ends of the second conductor 234.

As shown in Figure 4, each of the first conductor 214 and the second conductor 234 is partially embedded in the flexible substrate 250.

As described above in relation to the embodiment of Figure 2, in use, the first coil 210 is designated as an excitation coil, and the second coil 230 is designated as a pickup coil. Since the first coil 210 and the second coil 230 are identical to one another this designation may readily be reversed.

As shown in Figure 5, the eddy current probe 200 is connected to a controller 160. The controller 160 may be a computer or may be a sub-system of a further control system (not shown).

Except where mutually exclusive, any of the features may be employed separately or in combination with any other features and the disclosure extends to and includes all combinations and sub-combinations of one or more features described herein.

The foregoing description of various aspects of the disclosure has been presented for purposes of illustration and description. It is not intended to be exhaustive or to limit the disclosure to the precise form disclosed, and obviously, many modifications and variations are possible. Such modifications and variations that may be apparent to a person of skill in the art are included within the scope of the disclosure as defined by the accompanying claims.

## Claims

1. An eddy current probe (100) comprising:
a first planar coil (110);
a second planar coil (130); and
a flexible substrate (150),
wherein the first coil (110) comprises a first conductor (114) having a spiral geometry, the second coil (130) comprises a second conductor (134) having a spiral geometry, the first conductor (114) is arranged concentrically with the second conductor (134), with the first conductor (114) being juxtaposed with the second conductor (134), and the concentrically arranged first and second planar coils (110;130) are embedded within the flexible substrate (150).

2. The eddy current probe (100) as claimed in Claim 1, wherein the spiral geometry is a rectilinear spiral geometry.

3. The eddy current probe (100) as claimed in Claim 1 or Claim 2, wherein the first and second planar coils (110;130) are completely embedded within the flexible substrate (150).

4. The eddy current probe (100) as claimed in any one of Claims 1 to 3, wherein each of the first conductor (114) and the second conductor (134) has a width of between 30µm and 150µm.

5. The eddy current probe (100) as claimed in any one of Claims 1 to 4, wherein each of the first conductor (114) and the second conductor (134) has a height of between 30µm and 150µm.

6. The eddy current probe (100) as claimed in any one of Claims 1 to 5, wherein each of the first planar coil (110) and the second planar coil (130) has a pair of electrical connections (116) connected to opposing ends of the respective first and second conductors (114;134), and each respective pair of electrical connections (116) is positioned on opposing sides of the concentrically arranged first and second planar coils (110;130).

7. An eddy current system, the system comprising
an eddy current probe (100:200) as claimed in any one of Claims 1 to 6; and
a control unit (160),
wherein the control unit (160) is electrically connected to each of the first planar coil (110:210) and the second planar coil (130:230), and the control unit (160) is configured to transmit a first alternating current signal to one of the first planar coil (110:210) and the second planar coil (130:230), and to receive a second alternating current signal from the other one of the first planar coil (110:210) and the second planar coil (130:230).

8. The eddy current system as claimed in Claim 7, further comprising a component, wherein the first planar coil (110:210) is an excitation coil and the second planar coil (130:230) is a pickup coil, the eddy current probe (100:200) is positioned conformally over a surface of the component, the first alternating current signal being arranged to generate eddy currents in the component, the second alternating current being representative of a residual stress condition within the component, and the control unit (160) being further configured to process the second alternating current to provide a measure of the residual stress condition within the component..

9. The eddy current system as claimed in Claim 7 or Claim 8, wherein each of the first alternating current signal and the second alternating current signal has a sinusoidal signal profile.

10. A method of inspecting a component, the method comprising the steps of:
providing an eddy current probe (100) as claimed in any one of Claims 1 to 6, positioning the eddy current probe (100) conformally over a surface of the component;
generating a first alternating current signal in the first planar coil (110);
receiving a second alternating current signal in the second planar coil (130); and
processing the second alternating current signal to provide an indication of the magnitude and distribution of residual stress in the component.

11. A computer program that, when read by a computer, causes performance of the method as claimed in Claim 10.

12. A non-transitory computer readable storage medium comprising computer readable instructions that, when read by a computer, cause performance of the method as claimed in Claim 10.

13. A signal comprising computer readable instructions that, when read by a computer, cause performance of the method as claimed in Claim 10.
